# EUROPEAN PATENT SPECIFICATION

(11) **EP 4 502 633 B1**
(45) Date of publication and mention of the grant of the patent: **14.10.2026**
(21) Application number: 23816204.4
(22) Date of filing: 03.04.2023
(51) Int. Cl.: G01R 31/367, G01R 31/36, G01R 31/392, G01R 31/396, G01R 19/165, G06N 3/08, G06N 3/045, G06N 3/0464, G06N 3/04

(54) **BATTERY CELL LIFE DIAGNOSIS DEVICE AND OPERATION METHOD THEREOF**
VORRICHTUNG ZUR DIAGNOSE DER LEBENSDAUER EINER BATTERIEZELLE UND BETRIEBSVERFAHREN DAFÜR
DISPOSITIF DE DIAGNOSTIC DE LA DURÉE DE VIE D'UNE CELLULE DE BATTERIE ET SON PROCÉDÉ DE FONCTIONNEMENT

(30) Priority: 02.06.2022 KR 20220067847
(43) Date of publication of application: 05.02.2025
(73) Proprietor: LG Energy Solution, Ltd., Seoul 07335 (KR)
(72) Inventor: PARK, Kyu Tae, Daejeon 34122 (KR); CHOI, Jee Soon, Daejeon 34122 (KR)
(74) Representative: Plasseraud IP
(86) International application number: PCT/KR2023/004477
(87) International publication number: WO 2023/234538

(56) References cited:
- WO-A1-2021/089786
- JP-A- 2020 106 470
- JP-A- H09 215 207
- KR-A- 20160 101 506
- KR-A- 20200 119 383
- KR-A- 20210 128 181
- US-A1- 2020 200 825
- US-A1- 2022 120 818

## Description

### [TECHNICAL FIELD]

### CROSS-REFERENCE TO RELATED APPLICATION

This application claims priority to and the benefit of Korean Patent Application No. 10-2022-0067847 filed in the Korean Intellectual Property Office on June 2, 2022.

### TECHNICAL FIELD

Embodiments disclosed herein relate to a battery cell life diagnosis apparatus and an operating method thereof.

### [BACKGROUND ART]

Recently, research and development of secondary batteries have been actively performed. Secondary batteries, which are chargeable/dischargeable batteries, may include all of conventional nickel (Ni)/cadmium (Cd) batteries, Ni/metal hydride (MH) batteries, etc., and recent lithium-ion batteries. A lithium-ion battery has a much higher energy density than those of the conventional Ni/Cd batteries, Ni/MH batteries, etc. Moreover, the lithium-ion battery may be manufactured to be small and lightweight, such that the lithium-ion battery has been used as a power source of mobile devices, and recently, a use range thereof has been extended to power sources for electric vehicles, attracting attention as next-generation energy storage media.

Batteries tend to deteriorate as they are repeatedly charged and discharged. For example, as batteries are repeatedly charged and discharged, their capacity and resistance may deteriorate and their remaining life may decrease. In addition, the degree of deterioration and remaining life of the battery may change depending on use conditions.

When the remaining life of the battery rapidly decreases, safety issues may occur in the use of the battery. Accordingly, there is a need for a method of diagnosing the life of the battery in advance to prevent a risk caused by a sudden drop in battery performance. US2020/200825 A1, US2022/120818 A1 and JP H09 215207 A each relate to systems for estimating battery capacities.

### [DISCLOSURE]

### [TECHNICAL PROBLEM]

Embodiments disclosed herein aim to provide an apparatus for converting operating characteristic data of a battery cell, collected in time-series corresponding to an operating condition, into an image to effectively calculate a life of the battery cell, and an operating method of the apparatus.

Embodiments disclosed herein aim to provide an apparatus for diagnosing a life of a battery cell based on an image converted from time-series data and an operating method of the apparatus.

Technical problems of the embodiments disclosed herein are not limited to the above-described technical problems, and other unmentioned technical problems would be clearly understood by one of ordinary skill in the art from the following description.

### [TECHNICAL SOLUTION]

A battery cell diagnosis apparatus according to claim 1 is provided in a first aspect.

In an embodiment, the image may be an image corresponding to a two-dimensional space trajectory.

In an embodiment, the time-series data may be data corresponding to an operating characteristic change of the battery cell with respect to time.

In an embodiment, the extracting unit may be further configured to extract the feature value through a first neural network.

In an embodiment, the first neural network may be a convolution neural network including a convolution layer and a pooling layer.

In an embodiment, the calculating unit may be further configured to calculate the life through a second neural network.

In an embodiment, the second neural network may be a deep neural network including a plurality of hidden layers.

In an embodiment, the operating condition may correspond to the feature value, and the calculating unit may be further configured to generate a prediction function for the operating condition through a third neural network.

In an embodiment, the third neural network may be a deep neural network including a plurality of hidden layers.

In an embodiment, the calculating unit may be further configured to calculate the life based on the prediction function and the feature value.

A battery cell diagnosis method according to claim 11 is provided in a second aspect.

In an embodiment, the extracting of the feature value from the image may include extracting the feature value through a first neural network.

In an embodiment, the calculating of the life may include calculating the life through a second neural network, and the second neural network may be a deep neural network including a plurality of hidden layers.

In an embodiment, the operating condition may correspond to the feature value, and the calculating of the life may include generating a prediction function for the operating condition through a third neural network, connecting the prediction function to the feature value, and predicting the life based on the prediction function and the feature value.

### [ADVANTAGEOUS EFFECTS]

A battery cell life diagnosis apparatus and an operating method thereof according to an embodiment disclosed herein may calculate a state of a battery cell.

The battery cell diagnosis apparatus and the operating method thereof according to an embodiment disclosed herein may calculate the state of the battery cell by converting time-series data about operating characteristics of the battery cell into an image with preset dimensions.

The battery cell diagnosis apparatus and the operating method thereof according to an embodiment disclosed herein may calculate the remaining life of the battery cell by analyzing image data through a neural network.

The battery cell diagnosis apparatus and the operating method thereof according to an embodiment disclosed herein may improve the accuracy of calculation of the life of the battery cell based on an image corresponding to the operating characteristics of the battery cell and the operating condition of the battery cell.

Moreover, various effects recognized directly or indirectly from the disclosure may be provided.

### [DESCRIPTION OF DRAWINGS]

FIG. 1 is a block diagram of a battery cell diagnosis apparatus according to an embodiment disclosed herein.
FIG. 2 shows a time-series data processing method of a battery cell diagnosis apparatus according to an embodiment disclosed herein.
FIGS. 3A and 3B show an image converting method of a battery cell diagnosis apparatus according to an embodiment disclosed herein.
FIG. 4 shows a feature value extracting method of a battery cell diagnosis apparatus according to an embodiment disclosed herein.
FIG. 5 shows a SoH calculating method of a battery cell diagnosis apparatus according to an embodiment disclosed herein.
FIG. 6 shows a SoH calculating method of a battery cell diagnosis apparatus according to another embodiment disclosed herein.
FIG. 7 is a flowchart of an operating method of a battery cell diagnosis apparatus according to an embodiment disclosed herein.
FIG. 8 is a flowchart of an operating method of a battery cell diagnosis apparatus according to another embodiment disclosed herein.
FIG. 9 is a graph for comparing life prediction accuracies with an operating method of a diagnosis apparatus, according to an embodiment disclosed herein.
FIG. 10 is a block diagram showing a hardware configuration of a computing system for performing an operating method of a battery cell diagnosis apparatus, according to an embodiment disclosed herein.

### [MODE FOR INVENTION]

Hereinafter, embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present application.

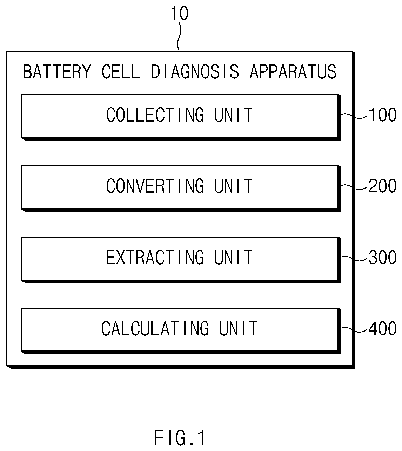

FIG. 1 is a block diagram of a battery cell diagnosis apparatus according to an embodiment disclosed herein.

Referring to FIG. 1, a battery cell diagnosis apparatus 10 according to an embodiment disclosed herein may include a collecting unit 100, a converting unit 200, an extracting unit 300, and a calculating unit 400.

The collecting unit 100 may obtain an operating condition of the battery cell and time-series data of the battery cell corresponding to the operating condition.

A state of health (SoH), which is an indicator indicating performance reduction of the battery cell, may be expressed as a percentage of a capacity or resistance of the battery cell reduced with respect to an initial capacity due to aging. A change in the SoH may occur due to resistance increase due to polarization of a chemical substance included in the battery cell. When the performance of the battery cell is reduced to a predefined threshold point or less, replacement of the battery cell may be required. Generally, when the initial capacity is at a level of 80 %, it may be determined as a life end time of the battery cell.

The operating condition may be a condition maintained constant to obtain operating characteristics during charge/discharge experiment for measuring a performance index of the battery cell. The operating characteristics of the battery cell may be a value obtained during the charge/discharge experiment according to the operating condition, and may be a value changing over time. The time-series data may be data obtained by measuring the operating characteristics of the battery cell in a predetermined time period. Thus, the time-series data may indicate a change in the operating characteristics of the battery cell over time.

The performance index of the battery cell may mean, for example, the above-described SoH or state of charge (SoC, a remaining capacity), etc.

The charge/discharge experiment may mean experiment for detecting the operating characteristics of the battery cell while maintaining the operating condition. The operating condition may mean an experimental environment that affects an output of the battery cell.

When the operating temperature and charge/discharge current of the battery cell are the operating conditions, the operating characteristics of the battery cell may be a charge/discharge voltage. In this case, the time-series data may be data indicating a change in the charge/discharge voltage of the battery cell over time.

The characteristics of the battery cell may be deteriorated as the number of repetition of charge/discharge increases. The collecting unit 100 may obtain the time-series data of the battery cell for each number of repetitions of charge/discharge. According to an embodiment, the number of repetitions of charge/discharge may be an operating condition of the battery cell.

The operating condition may be changed according to the time-series data to be obtained, and according to another embodiment, the operating characteristics may be an impedance, an internal resistance, a capacity, etc., of the battery cell.

According to an embodiment, the collecting unit 100 may include a measuring device for monitoring a temperature, a charge/discharge current, and a charge/discharge voltage of the battery cell to obtain the time-series data corresponding to the operating condition. The measuring device may also monitor an impedance, an internal resistance, a capacity, etc., of the battery cell.

In addition, according to another embodiment, the collecting unit 100 may receive matching of an operating condition of the battery cell with time-series data of the battery cell corresponding to the operating condition from an external source.

The time-series data may be data sampled or normalized at preset time intervals by the collecting unit 100. For example, when the operating temperatures and the charge/discharge current of the battery cell are maintained constant, once the collecting unit 100 collects raw data with respect to a charge/discharge voltage of the battery cell over time, the raw data may be divided at the preset time intervals to obtain a plurality of time-series data.

The converting unit 200 may convert the time-series data of the battery cell into an image corresponding to a space trajectory of predetermined dimensions. Conversion of the time-series data may be performed using a recurrence plot (RP) scheme. The RP scheme may be a conversion scheme used to convert the time-series data into an image.

The RP scheme may convert the time-series data into the space trajectory of predetermined dimensions and express a distance between points on the space trajectory into a distance matrix to convert the time-series data into the image. In this case, the space trajectory may mean a movement trajectory between data included in the time-series data.

The converting unit 200 may visualize the time-series data into the image corresponding to the space trajectory of predetermined dimensions, based on a distance value of the distance matrix.

According to an embodiment, the converting unit 200 may visualize the time-series data into the image by expressing a region corresponding to the distance matrix in two dimensions, when the distance value of the distance matrix is greater than or equal to a threshold value.

According to another embodiment, by expressing a color of the region corresponding to the distance matrix in two dimensions to change according to the distance value of the distance matrix, the region may be visualized as an image including a red channel, a green channel, and a blue channel.

The converting unit 200 may clearly reveal features that are difficult to identify from the time-series data by converting the time-series data into the image through the RP scheme.

The extracting unit 300 may extract a feature value of an image through a first neural network. According to an embodiment, the extracting unit 300 may generate a plurality of feature maps from the image. The extracting unit 300 may extract the feature value by processing the generated feature maps and transmit the extracted feature value to the calculating unit 400.

The first neural network may be a convolution neural network algorithm. The convolution neural network may be a deep learning algorithm including a convolution layer and a pooling layer, and the convolution layer may include a filter (a convolution kernel) that extracts a feature of an image and an activation function that calculates input data passing through the filter as a nonlinear value. The image passing through the convolution layer may be output as a plurality of feature maps.

The pooling layer may remove noise unrelated to features from the feature map.

The convolution neural network may have a different architecture according to a scheme for connection between the convolution layer and the pooling layer. The convolution neural network for extracting the feature value from the image may use, for example, AlexNet overlappingly using the convolution layer, GoogLeNet including an inception module, ResNet including a residual block, etc.

The first neural network used in the extracting unit 300 may use an existing trained model. According to an embodiment, the extracting unit 300 may use the GoogLeNet or ResNet model trained by a visual database (e.g., an imageNet project) for feature value extraction through transfer learning.

According to another embodiment, the extracting unit 300 may adjust a weight of the convolution kernel used in calculation or adjust an architecture of the trained convolution neural network in the convolution layer of the first neural network, thus optimizing the first neural network.

The first neural network used in the extracting unit 300 may vary with the amount of an image converted from the time-series data. That is, when the amount of an image converted from the time-series data is small, the neural network may use the existing trained model for feature value extraction through transfer learning, and when the amount of the image converted from the time-series data is large, the neural network may use the existing trained model by changing the architecture, the weight, etc., of the existing trained model.

According to an embodiment, the extracting unit 300 may generate a feature value by flattening and concatenating the plurality of feature maps generated. The number of feature maps may vary with the number of filters included in the first neural network. The feature map may be referred to as a layer.

The calculating unit 400 may predict or calculate a SoH of the battery cell through a second neural network. According to an embodiment, the second neural network may be a deep neural network algorithm. The calculating unit 400 may predict or calculate the SoH of the battery cell based on the feature value and the operating condition extracted from the image.

The deep neural network may be a deep learning algorithm including multiple hidden layers and may finely process a plurality of data of high complexity by using the plurality of hidden layers.

The second neural network included in the calculating unit 400 may learn the time-series data based on the feature value extracted through conversion into the image, thereby improving accuracy when compared to directly learning the time-series data to calculate the SoH of the battery cell.

When the time-series data is learned without conversion into the image, the feature of the data may not be properly reflected and a predicted value may be biased or a tendency of a local region may be excessively reflected, resulting in reduction of the calculation accuracy of the calculating unit 400.

For example, for time-series data that reflects a capacity change of a battery cell over time, noise may occur in the time-series data due to capacity regeneration in which a capacity irregularly increases by removal of a residual reaction product, and the noise may affect SoH prediction.

When the time-series data is converted into the image and the SoH is predicted based on the feature value extracted from the image, the image may recurrently reflect a change in the time-series data and easily extract the feature, thereby increasing SoH prediction accuracy of the calculating unit 400.

The deep neural network may have a different architecture according to a connection method of a hidden layer. The deep neural network may use, for example, a recurrent neural network (RNN) with hidden layers having a circular architecture, long short-term memory (LSTM) having added thereto a layer for memorizing a previous state to improve a gradient vanishing phenomenon and long-term dependence, etc.

The feature values input to the calculating unit 400 may be obtained by converting images that are the basis for feature value extraction from the time-series data, and may be analyzed together with sequential data by the second neural network. The sequential data may mean data that changes time-serially.

According to another embodiment, the calculating unit 400 may generate a prediction function by using an operating condition corresponding to the feature value. The calculating unit 400 may concatenate the feature value with the operating condition corresponding thereto.

The prediction function is a function that causes the second neural network to reflect a SoH change with the operating condition, in which as the second neural network learns the prediction function and the feature value by concatenating them with each other, tendency of the SoH change with the operating condition may be reflected in the second neural network. Thus, when the second neural network learns the prediction function and the feature value by concatenating them, the SoH prediction accuracy of the calculating unit 400 may be improved.

The extracting unit 300 may extract the feature value from the image converted from the time-series data in which a random operating condition may correspond to a feature value. The collecting unit 100 may transmit the operating condition corresponding to the feature value to the calculating unit 400. The calculating unit 400 may generate a prediction function through a third neural network.

According to an embodiment, the third neural network may be a deep neural network like the second neural network.

Learning using the second neural network and the third neural network may be learning using information of different dimensions (the feature values and the operating conditions), which may be referred to as multimodal learning.

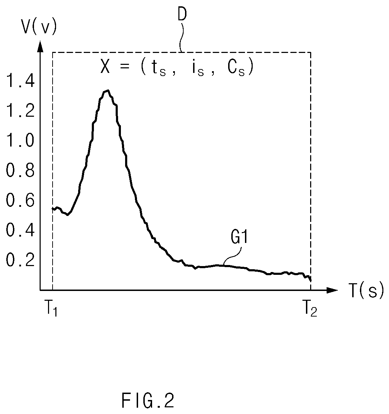

FIG. 2 shows a time-series data processing method of a battery cell diagnosis apparatus according to an embodiment disclosed herein.

In FIG. 2 is shown a first graph G1 of time-series data with respect to a random operating condition X.

The collecting unit 100 may collect a charge/discharge voltage V of a battery cell with respect to a time T when a preset temperature tₛ, a preset charge/discharge current iₛ, and a preset number of times of charge/discharge Cₛ are operating conditions X. That is, the first graph G1 may indicate the charge/discharge voltage V of the battery cell with respect to the time T.

The collecting unit 100 may collect a plurality of time-series data by dividing the charge/discharge voltage V of the battery cell with respect to the time T by a preset time interval. In FIG. 2 is shown a case where the collecting unit 100 collects time-series data D divided from a first time T₁ to a second time T₂.

The collecting unit 100 may collect the time-series data by dividing the same at random time intervals, and according to another embodiment, the plurality of time-series data may include overlapping time domains.

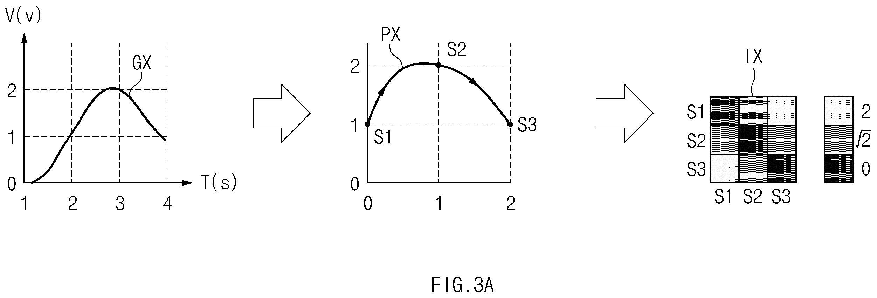

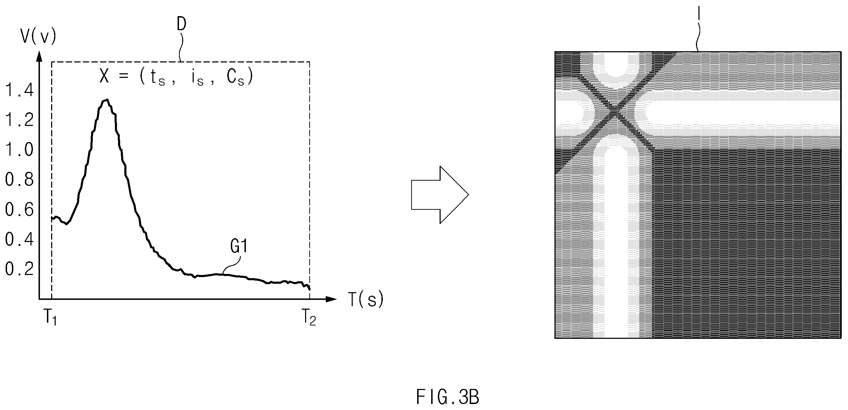

FIGS. 3A and 3B show an image converting method of a battery cell diagnosis apparatus according to an embodiment disclosed herein.

The converting unit 200 may convert time-series data D into an image I using the RP scheme.

To describe the RP scheme, an example graph GX having a time axis T and a voltage axis V is shown. Hereinbelow, a process of converting the example graph GX into an example image IX will be described in detail with reference to FIG. 3A.

The example graph GX may be converted into an example space trajectory PX that is a two-dimensional space trajectory. Points S1, S2, and S3 on the example space trajectory may indicate a change in a value along the voltage axis V with respect to a change in a value along the time axis T.

That is, S1 may indicate, as coordinates (0, 1), a change in a value along the voltage axis V from 0 to 1 during a change in a value along the time axis T from 1 to 2. Likewise, S2 may indicate, as coordinates (1, 2), a change in a value along the voltage axis V from 1 to 2 during a change in a value along the time axis T from 2 to 3.

The space trajectory may indicate a movement trajectory of data included in the time-series data. Thus, points located on the space trajectory may recurrently indicate a relationship between adjacent data included in the time-series data.

The distance matrix may be, for example, a matrix including points located on the space trajectory. For example, the distance matrix may have a form such as (S1, S2) or (S1, S3).

The distance value of the distance matrix may mean a distance between points on the space trajectory. According to an embodiment, the time-series data may be visualized into the image by expressing a color of a region corresponding to the distance matrix to change with the distance value of the distance matrix. For example, distance values of a distance matrix (S1, S2) may be a distance $\sqrt{2}$ between S1 and S2. Likewise, distance values of a distance matrix (S1, S3) may be 2 that is a distance between S1 and S3.

Referring to the example image IX, a contrast of a corresponding region may change with the distance value of the distance matrix.

The RP scheme may express the distance between the points located on the space trajectory as the distance matrix in which the image expressed with the RP scheme may have a symmetric shape.

In FIG. 3B is shown a process of converting the time-series data D of FIG. 2 into the image data I according to the RP scheme. Features of the image I converted with the RP scheme may be more clearly revealed than the first graph G1 representing the time-series data.

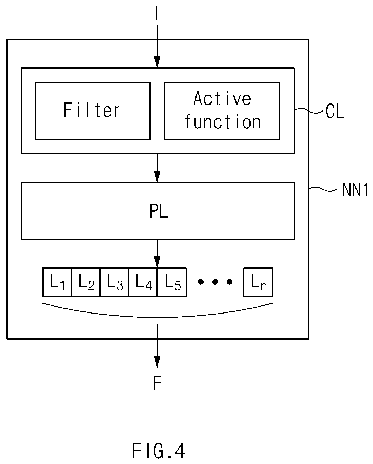

FIG. 4 shows a feature value extracting method of a battery cell diagnosis apparatus according to an embodiment disclosed herein.

The extracting unit 300 may receive the image I and extract a feature value from the image I received through a first neural network NN1.

The first neural network NN1 may include a convolution layer CL and a pooling layer PL.

The convolution layer CL may include a filter and an activation function and generate a feature map from the image I. The pooling layer PL may remove noise from the extracted feature map and adjust a size of the feature map.

Although it is shown that the first neural network NN1 includes one convolution layer CL and one pooling layer PL, the first neural network NN1 may include a plurality of convolution layers CL and pooling layers PL that may have various architectures according to a purpose of the first neural network NN1.

The number of feature maps generated from the image I may change with the number of filters included in the convolution layer CL. That is, a plurality of feature maps may be output after one image passes through the convolution layer CL and the pooling layer PL, and the feature maps may be referred to as layers L₁, L₂, L₃, L₄, L₅, ..., Lₙ.

The extracting unit 300 may extract a feature value F by flattening and concatenating the feature maps generated from the image I. The generated feature value may correspond to the time-series data D.

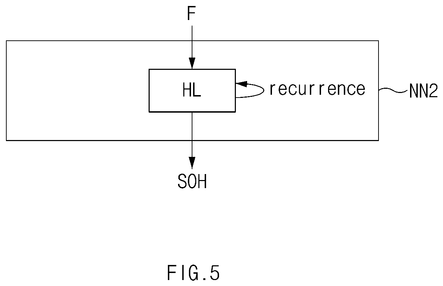

FIG. 5 shows a SoH calculating method of a battery cell diagnosis apparatus according to an embodiment disclosed herein.

The calculating unit 400 may receive the feature value F, and a second neural network NN2 may be trained based on the received feature value F. The trained second neural network NN2 may calculate or predict a SoH based on the feature value F. The second neural network NN2 may include a hidden layer HL that is shown as having a circular architecture as an example, but a neural network having another architecture may be selected depending on an embodiment. The hidden layer HL may be trained using a recurrence algorithm and predict or calculate a SoH.

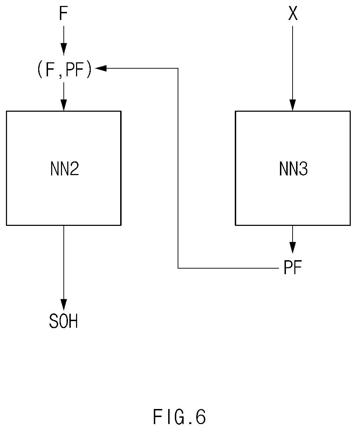

FIG. 6 shows a SoH calculating method of a battery cell diagnosis apparatus according to another embodiment disclosed herein.

The calculating unit 400 may receive an operating condition X from the collecting unit 100 and calculate a prediction function PF through a third neural network NN3. The third neural network NN3 may be, for example, an RNN, and the calculated prediction function PF may correspond to a random feature value.

The calculating unit 400 may connect the feature value F to the prediction function PF. For example, the feature value F extracted in FIG. 2 may be based on the time-series data D collected under the operating condition X (tₛ, iₛ, Cₛ), and may be connected to the prediction function PF obtained from the operating condition X.

The second neural network NN2 included in the calculating unit 400 may be trained based on the connected feature value and prediction function (F, PF) and calculate a SoH based on the connected feature value and prediction function (F, PF). The second neural network NN2 may reflect a SoH change according to the operating condition by using the prediction function PF for training.

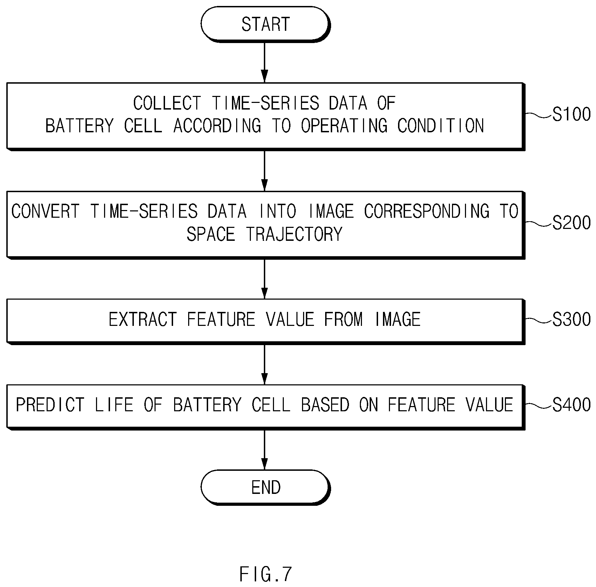

FIG. 7 is a flowchart of an operating method of a battery cell diagnosis apparatus according to an embodiment disclosed herein.

Referring to FIG. 7, the battery cell diagnosis apparatus may collect the time-series data according to the operating condition of the battery cell, in operation S100. As described above, the operating condition of the battery cell may mean a condition maintained constant during charge/discharge of the battery cell. The collected time-series data may be data showing operating characteristics obtained during charge/discharge experiment according to the operating condition with respect to time.

For example, the operating condition may include charge/discharge current of the battery cell, a temperature of the battery cell in charge/discharge, charge/discharge voltage of the battery cell, the number of times of charge/discharge of the battery cell, etc.

The time-series data may be data obtained by sampling the operating characteristics at predetermined time intervals.

The battery cell diagnosis apparatus may convert the time-series data into an image corresponding to the space trajectory of predetermined dimensions, in operation S200. The battery cell diagnosis apparatus may convert the time-series data into an image according to the RP scheme. The RP scheme may convert the time-series data into the space trajectory of predetermined dimensions and express a distance between points on the converted space trajectory into a distance matrix to convert the time-series data into the image. According to an embodiment, the predetermined dimensions may be two dimensions.

The battery cell diagnosis apparatus may extract a feature value from the image, in operation S300. The battery cell diagnosis apparatus may use a first neural network for extracting a feature value, and for example, the first neural network may be a convolution neural network including a convolution layer and a pooling layer. More specifically, the battery cell diagnosis apparatus may use AlexNet, GoogLeNet, ResNet, etc., to extract a feature value from an image.

The battery cell diagnosis apparatus may calculate a life of the battery cell based on the extracted feature value, in operation S400. The battery cell diagnosis apparatus may train the second neural network based on the feature value and predict the SoH of the battery cell by using the trained second neural network. The second neural network may be a deep neural network including a hidden layer, and more specifically, the battery cell diagnosis apparatus may use an RNN, an LSTM, etc., to predict a SoH.

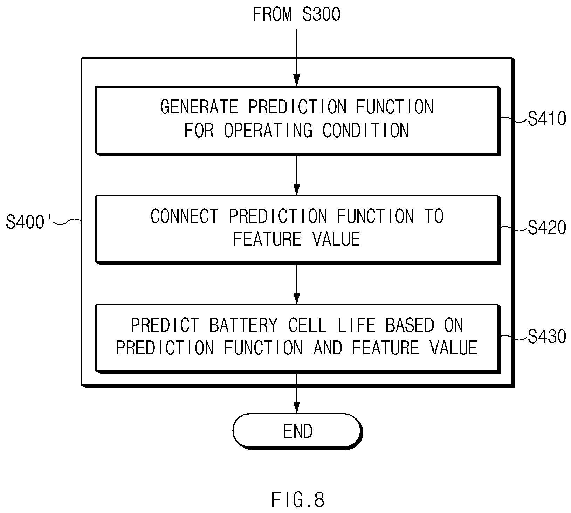

FIG. 8 is a flowchart of an operating method of a battery cell diagnosis apparatus according to another embodiment disclosed herein.

With reference to FIG. 8, a description will be made of a method for the battery cell diagnosis apparatus to predict a SoH of a battery cell by reflecting a prediction function.

The battery cell diagnosis apparatus may extract a feature value from an image in operation S300, and then predict a SoH using a method that is different from the method described with reference to FIG. 7 in operation S400'.

The battery cell diagnosis apparatus may generate the prediction function for an operating condition based on the third neural network, in operation S410.

The prediction function is a value generated by calculating the operating condition with the third neural network, and the battery cell diagnosis apparatus may connect the prediction function with a corresponding feature value in operation S420 and predict a life of the battery cell based on the prediction function and the feature value in operation S430. The battery cell diagnosis apparatus may learn the second neural network by connecting the prediction function to the feature value, thereby improving the accuracy of SoH prediction of the second neural network.

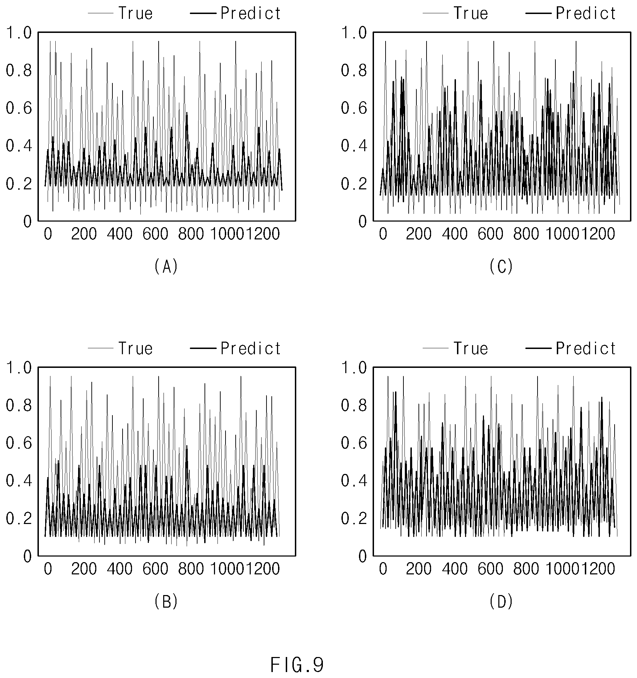

FIG. 9 is a graph for comparing life prediction accuracies with an operating method of a diagnosis apparatus, according to an embodiment disclosed herein.

A True graph of FIG. 9 plots a SoH value calculated from the plurality of operating conditions and the time-series data as a maximum value of 1, a Predict graph plots a SoH value predicted by the battery cell diagnosis apparatus based on the operating condition and the image-series data as a maximum value of 1. A horizontal axis of a graph may indicate the number of samples used for prediction.

A and B of FIG. 9 are graphs that predict a SoH based on a model trained without conversion of time-series data into an image. However, B is a graph of a model trained by reflecting a prediction function based on an operating condition. The model of B may have a higher prediction accuracy than the model of A.

C and D of FIG. 9 are graphs that predict a SoH based on a model trained through conversion of time-series data into an image. However, D is a graph of a model that predicts a SoH by reflecting a prediction function based on an operating condition. It may be seen that prediction accuracy of the models of C and D, trained through image conversion, is improved when compared to that of the models of A and B, trained without image conversion. Moreover, when training is performed by reflecting the prediction function, the prediction accuracy may be further improved.

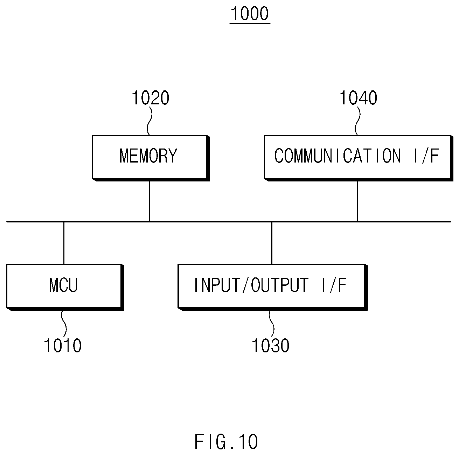

FIG. 10 is a block diagram showing a hardware configuration of a computing system for performing an operating method of a battery cell diagnosis apparatus, according to an embodiment disclosed herein.

Referring to FIG. 10, a computing system 1000 according to an embodiment disclosed herein may include an MCU 1010, a memory 1020, an input/output I/F 1030, and a communication I/F 1040.

The MCU 1010 may be a processor that executes various programs (e.g., a battery pack voltage or current collection program, a control program of a relay included in a battery pack, a battery cell remaining life calculating program, a battery cell capacity deterioration diagnosis program, a battery cell resistance deterioration determining program, etc.) stored in the memory 1020, processes various information including remaining life information of the battery cell, capacity deterioration information of the battery cell, and resistance deterioration information of the battery cell through these programs, and executes the above-described functions of the battery cell diagnosis apparatus shown in FIG. 1.

The memory 1020 may store various programs regarding log information collection and diagnosis of the battery, etc. The memory 1020 may store various information current, voltage, and charge/discharge condition information of the battery, voltage information of the battery cell in a charge/discharge cycle period within a preset number of times, dQ/dV information of the battery cell in the charge/discharge cycle period within a preset number of times, etc.

The memory 1020 may be provided in plural, depending on a need. The memory 1020 may be volatile memory or non-volatile memory. For the memory 1020 as the volatile memory, random access memory (RAM), dynamic RAM (DRAM), static RAM (SRAM), etc., may be used. For the memory 1020 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 1020 are merely examples and are not limited thereto.

The input/output I/F 1030 may provide an interface for transmitting and receiving data by connecting an input device (not shown) such as a keyboard, a mouse, a touch panel, etc., and an output device such as a display (not shown), etc., to the MCU 1010.

The communication I/F 1040, which is a component capable of transmitting and receiving various data to and from a server, may be various devices capable of supporting wired or wireless communication. For example, the battery cell diagnosis apparatus may transmit and receive a relay control program included in a battery pack or information such as a current, a current, a value dQ/dV, charging/discharging condition information, remaining life, capacity deterioration, or resistance deterioration information of various battery packs from an external server separately provided through the communication I/F 1040.

As such, a computer program according to an embodiment disclosed herein may be recorded in the memory 1020 and processed by the MCU 1010, thus being implemented as a module that performs functions shown in FIG. 1.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

Therefore, the embodiments disclosed herein are intended for description rather than limitation of the technical spirit of the embodiments disclosed herein and the scope of the present disclosure is not limited by these embodiments disclosed herein. The protection scope of the invention should be interpreted by the following claims.

## Claims

1. A battery cell diagnosis apparatus (10) comprising:
a collecting unit (100) configured to collect time-series data of a battery cell according to an operating condition;
a converting unit (200) configured to convert the time-series data into an image corresponding to a space trajectory of predetermined dimensions by:
converting the time-series data into the space trajectory and
converting the time-series data into the image by using the space trajectory;
an extracting unit (300) configured to extract a feature value from the image; and
a calculating unit (400) configured to calculate a life of the battery cell based on the feature value;
wherein the converting unit (200) is further configured to express a distance between points located on the space trajectory as a distance matrix by using a recurrence plot, RP, scheme, and
a region corresponding to the distance matrix is converted into the image based on a distance value of the distance matrix.

2. The battery cell diagnosis apparatus (10) of claim 1, wherein the image is an image corresponding to a two-dimensional space trajectory.

3. The battery cell diagnosis apparatus (10) of claim 1, wherein the time-series data is data corresponding to an operating characteristic change of the battery cell with respect to time.

4. The battery cell diagnosis apparatus (10) of claim 1, wherein the extracting unit (300) is further configured to extract the feature value through a first neural network.

5. The battery cell diagnosis apparatus (10) of claim 4, wherein the first neural network is a convolution neural network comprising a convolution layer and a pooling layer.

6. The battery cell diagnosis apparatus (10) of claim 1, wherein the calculating unit (400) is further configured to calculate the life through a second neural network.

7. The battery cell diagnosis apparatus (10) of claim 6, wherein the second neural network is a deep neural network comprising a plurality of hidden layers.

8. The battery cell diagnosis apparatus (10) of claim 1, wherein the operating condition corresponds to the feature value, and
the calculating unit (400) is further configured to generate a prediction function for the operating condition through a third neural network.

9. The battery cell diagnosis apparatus (10) of claim 8, wherein the third neural network is a deep neural network comprising a plurality of hidden layers.

10. The battery cell diagnosis apparatus (10) of claim 8, wherein the calculating unit (400) is further configured to calculate the life based on the prediction function and the feature value.

11. A battery cell diagnosis method comprising:
collecting (S100) time-series data of a battery cell according to an operating condition;
converting (S200) the time-series data into an image corresponding to a space trajectory of predetermined dimensions by:
converting the time-series data into a space trajectory; and
converting the time-series data into the image by using the space trajectory;
extracting (S300) a feature value from the image; and
calculating (S400) a life of the battery cell based on the feature value;
wherein the converting (S200) the time series data into the image by using the space trajectory comprises:
expressing a distance between points located on the space trajectory as a distance matrix by using a recurrence plot, RP, scheme; and
visualizing a region corresponding to the distance matrix based on a distance value of the distance matrix.

## Patentansprüche

1. Batteriezellendiagnosevorrichtung (10), umfassend:
eine Sammeleinheit (100), die konfiguriert ist, um Zeitreihendaten einer Batteriezelle gemäß einer Betriebsbedingung zu sammeln;
eine Umwandlungseinheit (200), die konfiguriert ist, um die Zeitreihendaten in ein Bild umzuwandeln, das einer Raumtrajektorie vorbestimmter Dimensionen entspricht, durch:
Umwandeln der Zeitreihendaten in die Raumtrajektorie und
Umwandeln der Zeitreihendaten in das Bild unter Verwendung der Raumtrajektorie;
eine Extraktionseinheit (300), die konfiguriert ist, um einen Merkmalswert aus dem Bild zu extrahieren; und
eine Berechnungseinheit (400), die konfiguriert ist, um eine Lebensdauer der Batteriezelle auf der Grundlage des Merkmalswerts zu berechnen;
wobei die Umwandlungseinheit (200) ferner konfiguriert ist, um einen Abstand zwischen Punkten, die sich auf der Raumtrajektorie befinden, als eine Abstandsmatrix unter Verwendung eines Recurrence-Plot-, RP-, Schemas auszudrücken, und
ein Bereich, der der Abstandsmatrix entspricht, auf der Grundlage eines Abstandswerts der Abstandsmatrix in das Bild umgewandelt wird.

2. Batteriezellendiagnosevorrichtung (10) nach Anspruch 1, wobei das Bild ein Bild ist, das einer zweidimensionalen Raumtrajektorie entspricht.

3. Batteriezellendiagnosevorrichtung (10) nach Anspruch 1, wobei die Zeitreihendaten Daten sind, die einer Änderung der Betriebscharakteristik der Batteriezelle in Bezug auf die Zeit entsprechen.

4. Batteriezellendiagnosevorrichtung (10) nach Anspruch 1, wobei die Extraktionseinheit (300) ferner konfiguriert ist, um den Merkmalswert durch ein erstes neuronales Netz zu extrahieren.

5. Batteriezellendiagnosevorrichtung (10) nach Anspruch 4, wobei das erste neuronale Netz ein Faltungsneuronales Netz ist, das eine Faltungsschicht und eine Pooling-Schicht umfasst.

6. Batteriezellendiagnosevorrichtung (10) nach Anspruch 1, wobei die Berechnungseinheit (400) ferner konfiguriert ist, um die Lebensdauer durch ein zweites neuronales Netz zu berechnen.

7. Batteriezellendiagnosevorrichtung (10) nach Anspruch 6, wobei das zweite neuronale Netz ein tiefes neuronales Netz ist, das eine Vielzahl von verborgenen Schichten umfasst.

8. Batteriezellendiagnosevorrichtung (10) nach Anspruch 1, wobei die Betriebsbedingung dem Merkmalswert entspricht, und
die Berechnungseinheit (400) ferner konfiguriert ist, um eine Prädiktionsfunktion für die Betriebsbedingung durch ein drittes neuronales Netz zu erzeugen.

9. Batteriezellendiagnosevorrichtung (10) nach Anspruch 8, wobei das dritte neuronale Netz ein tiefes neuronales Netz ist, das eine Vielzahl von verborgenen Schichten umfasst.

10. Batteriezellendiagnosevorrichtung (10) nach Anspruch 8, wobei die Berechnungseinheit (400) ferner konfiguriert ist, um die Lebensdauer auf der Grundlage der Prädiktionsfunktion und des Merkmalswerts zu berechnen.

11. Batteriezellendiagnoseverfahren, umfassend:
Sammeln (S100) von Zeitreihendaten einer Batteriezelle gemäß einer Betriebsbedingung;
Umwandeln (S200) der Zeitreihendaten in ein Bild, das einer Raumtrajektorie vorbestimmter Dimensionen entspricht, durch:
Umwandeln der Zeitreihendaten in eine Raumtrajektorie; und
Umwandeln der Zeitreihendaten in das Bild unter Verwendung der Raumtrajektorie;
Extrahieren (S300) eines Merkmalswerts aus dem Bild; und
Berechnen (S400) einer Lebensdauer der Batteriezelle auf der Grundlage des Merkmalswerts;
wobei das Umwandeln (S200) der Zeitreihendaten in das Bild unter Verwendung der Raumtrajektorie umfasst:
Ausdrücken eines Abstands zwischen Punkten, die sich auf der Raumtrajektorie befinden, als eine Abstandsmatrix unter Verwendung eines Recurrence-Plot-, RP-, Schemas; und
Visualisieren eines Bereichs, der der Abstandsmatrix entspricht, auf der Grundlage eines Abstandswerts der Abstandsmatrix.

## Revendications

1. Appareil de diagnostic de cellule de batterie (10) comprenant :
une unité de collecte (100) configurée pour collecter des données de série chronologique d'une cellule de batterie selon une condition de fonctionnement ;
une unité de conversion (200) configurée pour convertir les données de série chronologique en une image correspondant à une trajectoire spatiale de dimensions prédéterminées en :
convertissant les données de série chronologique en la trajectoire spatiale et
convertissant les données de série chronologique en l'image en utilisant la trajectoire spatiale ;
une unité d'extraction (300) configurée pour extraire une valeur de caractéristique de l'image ; et
une unité de calcul (400) configurée pour calculer une durée de vie de la cellule de batterie sur la base de la valeur de caractéristique ;
dans lequel l'unité de conversion (200) est en outre configurée pour exprimer une distance entre des points situés sur la trajectoire spatiale sous forme de matrice de distances en utilisant un schéma de diagramme de récurrence, RP, et
une région correspondant à la matrice de distances est convertie en l'image sur la base d'une valeur de distance de la matrice de distances.

2. L'appareil de diagnostic de cellule de batterie (10) selon la revendication 1, dans lequel l'image est une image correspondant à une trajectoire spatiale bidimensionnelle.

3. L'appareil de diagnostic de cellule de batterie (10) selon la revendication 1, dans lequel les données de série chronologique sont des données correspondant à un changement de caractéristique de fonctionnement de la cellule de batterie par rapport au temps.

4. L'appareil de diagnostic de cellule de batterie (10) selon la revendication 1, dans lequel l'unité d'extraction (300) est en outre configurée pour extraire la valeur de caractéristique par l'intermédiaire d'un premier réseau neuronal.

5. L'appareil de diagnostic de cellule de batterie (10) selon la revendication 4, dans lequel le premier réseau neuronal est un réseau neuronal convolutif comprenant une couche de convolution et une couche de pooling.

6. L'appareil de diagnostic de cellule de batterie (10) selon la revendication 1, dans lequel l'unité de calcul (400) est en outre configurée pour calculer la durée de vie par l'intermédiaire d'un deuxième réseau neuronal.

7. L'appareil de diagnostic de cellule de batterie (10) selon la revendication 6, dans lequel le deuxième réseau neuronal est un réseau neuronal profond comprenant une pluralité de couches cachées.

8. L'appareil de diagnostic de cellule de batterie (10) selon la revendication 1, dans lequel la condition de fonctionnement correspond à la valeur de caractéristique, et
l'unité de calcul (400) est en outre configurée pour générer une fonction de prédiction pour la condition de fonctionnement par l'intermédiaire d'un troisième réseau neuronal.

9. L'appareil de diagnostic de cellule de batterie (10) selon la revendication 8, dans lequel le troisième réseau neuronal est un réseau neuronal profond comprenant une pluralité de couches cachées.

10. L'appareil de diagnostic de cellule de batterie (10) selon la revendication 8, dans lequel l'unité de calcul (400) est en outre configurée pour calculer la durée de vie sur la base de la fonction de prédiction et de la valeur de caractéristique.

11. Procédé de diagnostic de cellule de batterie comprenant :
la collecte (S100) de données de série chronologique d'une cellule de batterie selon une condition de fonctionnement ;
la conversion (S200) des données de série chronologique en une image correspondant à une trajectoire spatiale de dimensions prédéterminées en :
convertissant les données de série chronologique en une trajectoire spatiale ; et
convertissant les données de série chronologique en l'image en utilisant la trajectoire spatiale ;
l'extraction (S300) d'une valeur de caractéristique de l'image ; et
le calcul (S400) d'une durée de vie de la cellule de batterie sur la base de la valeur de caractéristique ;
dans lequel la conversion (S200) des données de série chronologique en l'image en utilisant la trajectoire spatiale comprend :
l'expression d'une distance entre des points situés sur la trajectoire spatiale sous forme de matrice de distances en utilisant un schéma de diagramme de récurrence, RP ; et
la visualisation d'une région correspondant à la matrice de distances sur la base d'une valeur de distance de la matrice de distances.
